# FASCICULE DE BREVET EUROPEEN

(11) **EP 3 052 798 B1**
(45) Date de publication et mention de la délivrance du brevet: **14.11.2018**
(21) Numéro de dépôt: 14761384.8
(22) Date de dépôt: 09.09.2014
(51) Int. Cl.: F01N 5/02, F02M 26/30, F28D 21/00, F25B 21/02, F28D 7/16, H01L 35/30

(54) **MODULE THERMO ÉLECTRIQUE, DISPOSITIF THERMO ÉLECTRIQUE, ÉCHANGEUR DE CHALEUR ET BOUCLE EGR**
THERMOELECTRIC MODULE, THERMOELECTRIC DEVICE, HEAT EXCHANGER AND EGR CIRCUIT
THERMOELEKTRISCHES MODUL, THERMOELEKTRISCHE VORRICHTUNG, WÄRMETAUSCHER UND AGR-KREISLAUF

(30) Priorité: 10.09.2013 FR 1358714
(43) Date de publication de la demande: 10.08.2016
(73) Titulaire: Valeo Systemes Thermiques, 78321 Le Mesnil-Saint-Denis (FR)
(72) Inventeur: AZZOUZ, Kamel, 75012 Paris (FR); DE PELSEMAEKER, Georges, 78125 Poigny-la-Foret (FR); DE VAULX, Cèdric, 78770 Autouillet (FR)
(74) Mandataire: Metz, Gaëlle
(86) Numéro de dépôt international: PCT/EP2014/069228
(87) Numéro de publication internationale: WO 2015/036408

(56) Documents cités:
- EP-A2- 2 477 246
- WO-A1-2011/006978
- WO-A1-2012/025476
- WO-A1-2012/041561
- AT-A2- 506 262
- DE-A1-102006 019 282
- DE-A1-102012 108 225
- US-A1- 2006 157 102

## Description

La présente invention concerne un module thermo électrique, un dispositif thermo électrique comprenant un tel module, un échangeur de chaleur comprenant un tel dispositif et une boucle EGR (Exhaust Gas Recirculation selon l'acronyme anglais) comprenant un tel échangeur.

Il a déjà été proposé des modules thermo électriques utilisant des éléments, dits thermo électriques, permettant de générer un courant électrique en présence d'un gradient de température entre deux de leurs faces opposées selon le phénomène connu sous le nom d'effet Seebeck. Ces dispositifs comprennent un empilement de premiers tubes, destinés à la circulation des gaz d'échappement d'un moteur, et de seconds tubes, destinés à la circulation d'un fluide caloporteur d'un circuit de refroidissement. Les éléments thermo électriques sont pris en sandwich entre les tubes de façon à être soumis à un gradient de température provenant de la différence de température entre les gaz d'échappement, chauds, et le fluide de refroidissement, froid.

Ces empilements de premiers tubes, d'éléments thermo électriques et de seconds tubes sont cependant d'une structure complexe et nécessite un assemblage précis et compliqué pour assurer un bon contact entre les tubes et les éléments thermo électriques.

Les documents WO2011/006978A1 et EP2477246A2 proposent des éléments thermo électriques agencés entre un conduit de circulation d'un liquide de refroidissement et une paroi externe le long de laquelle s'écoulent les gaz d'échappement. Une enveloppe isolante entoure les éléments thermo électriques.

L'invention vise à améliorer la situation. Elle concerne pour cela un module thermo électrique, comprenant au moins un élément thermo électrique permettant la génération d'un courant électrique à partir d'un gradient de température appliqué entre deux de ses faces actives, un premier circuit, dit chaud, apte à permettre la circulation d'un premier fluide en relation d'échange thermique avec l'une desdites faces actives et une gaine entourant le ou lesdits éléments thermo électriques et ledit circuit chaud de sorte que la gaine est agencée pour établir un contact thermique entre un liquide, dit froid, de température inférieure à celle du premier fluide, et l'autre desdites faces actives et séparer hermétiquement d'une part ledit liquide froid et d'autre part le ou lesdits éléments thermo électriques et ledit circuit chaud.

Ainsi, grâce à l'invention, on peut utiliser comme fluide froid un liquide sans que ce dernier ne circule dans un empilement complexe de tube froid. On dispose ainsi d'une large liberté de conception des dispositifs thermo électriques destinés à accueillir lesdits modules.

Selon différents modes de réalisation de l'invention, qui pourront être pris ensemble ou séparément :
- l'élément thermo électrique est de forme annulaire de sorte qu'il comprend une face intérieure, correspondant à la face active en relation d'échange thermique avec le circuit chaud, et une face extérieure, correspondant à l'autre desdites faces actives ;
- l'élément thermo électrique est de section transversale aplatie ;
- la gaine est isolante électrique ;
- le module thermo électrique comprend des intercalaires isolant électriquement deux éléments thermo électriques voisins au niveau d'une de leurs faces actives ;
- la gaine comprend lesdits intercalaires ;
- la gaine est thermo rétractable ;
- le premier circuit comprend au moins un tube traversant lesdits éléments thermo électriques.

L'invention concerne aussi un dispositif thermo électrique comprenant un boitier et au moins un module thermo électrique tel que décrit précédemment, ledit module étant inséré dans le boitier et ledit boitier comprenant une première zone dans laquelle ledit liquide froid est destiné à être en contact avec ladite gaine.

Avantageusement, ledit boitier définit, au moins en partie, un deuxième circuit dans lequel ledit liquide froid est destiné à circuler.

L'invention concerne également un échangeur de chaleur comprenant un dispositif thermo électrique tel que décrit précédemment, ledit boitier comprenant une deuxième zone dans laquelle le circuit chaud est configuré pour être directement en contact avec le liquide froid.

On assure ainsi à l'aide d'un seul et même échangeur, d'une part une fonction d'échange de chaleur permettant de refroidir le fluide chaud et de réchauffer le liquide froid, et, d'autre part, une fonction d'apport des sources chaudes et froides nécessaires au fonctionnement des éléments thermo électriques.

Cela étant, l'invention concerne encore un tel échangeur de chaleur, configuré pour être positionné dans un circuit de recirculation des gaz d'échappement, sans que lesdits modules thermo électriques comprennent la gaine mentionnée plus haut. Il suffira qu'ils soient configurés pour permettre de créer un gradient de température entre lesdites faces actives du ou desdits éléments thermo électriques à partir dudit circuit chaud, parcouru par lesdits gaz d'échappement recirculés, et un circuit froid parcouru par un liquide froid, notamment un circuit froid comprenant des tubes.

Selon différents modes de réalisation de l'invention, qui pourront être pris ensemble ou séparément :
- la première zone et la deuxième zone sont positionnées en séries dans le sens de circulation du fluide chaud ;
- le premier circuit est configuré de sorte que la première zone est située en amont de la deuxième zone dans le sens de circulation du fluide chaud ;
- l'échangeur est configuré de sorte que le liquide froid est destiné à parcourir parallèlement la première zone et la deuxième zone ;
- l'échangeur comprend une cloison séparant la première zone de la deuxième zone de sorte que le liquide froid circulant dans la première zone et le liquide froid circulant dans la deuxième zone sont séparés ;
- la première zone et la deuxième zone sont situées en séries dans le sens de circulation du liquide froid ;
- la première zone représente 40% à 90 % d'un volume défini par l'intérieur du boitier, la deuxième zone représentant la portion restante dudit volume ;
- la première zone représente 50% d'un volume défini par l'intérieur du boitier, la deuxième zone représentant 50% de ce volume ;
- la première zone représente 80% d'un volume défini par l'intérieur du boitier, la deuxième zone représentant 20% de ce volume.
- le fluide chaud comprend des gaz EGR ;

L'invention concerne encore un circuit de recirculation des gaz EGR d'un véhicule automobile comprenant un dispositif thermo électrique ou un échangeur de chaleur tel que décrit précédemment.

En effet, la dimension de l'échangeur étant réduite, il est possible de l'intégrer dans un conduit de recirculation des gaz d'échappement du véhicule automobile.

L'invention sera mieux comprise à la lumière de la description suivante qui n'est donnée qu'à titre indicatif et qui n'a pas pour but de la limiter, accompagnée des dessins joints parmi lesquels :
- la figure 1 représente de manière schématique, en perspective éclatée, un module thermo électrique conforme à l'invention ;
- la figure 2 illustre de façon schématique, en coupe, le module thermo électrique de la figure 1 ;
- la figure 3 représente, en perspective éclatée, un dispositif thermo électrique comprenant ledit module ;
- la figure 4 illustre de façon schématique, en coupe transversale, un échangeur de chaleur conforme à l'invention comprenant le dispositif thermo électrique de l'invention ;
- la figure 5 illustre, de façon schématique, en coupe latérale, une partie de l'échangeur de chaleur illustré à la figure 4.

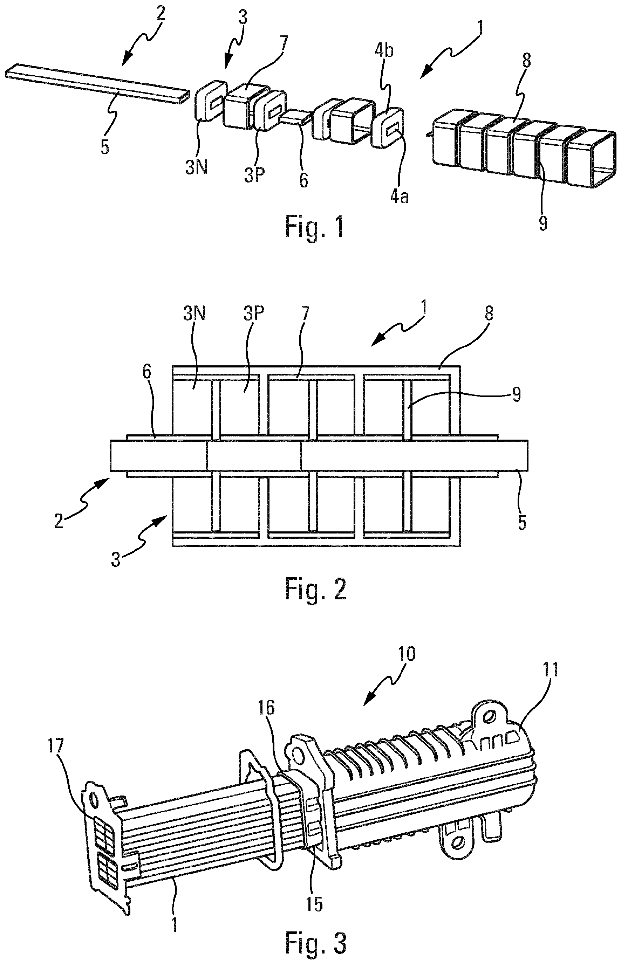

L'invention concerne un module thermo électrique 1 tel que représenté sur les figures 1 et 2. Un tel module 1 comprend un premier circuit 2, dit chaud, apte à permettre la circulation d'un premier fluide, notamment des gaz d'échappement d'un moteur. Le premier circuit 2 comprend ici un tube 5.

Le module 1 comprend également une pluralité d'élément thermo électrique 3 susceptibles de générer un courant électrique sous l'action d'un gradient de température exercé entre deux de leurs faces actives 4a, 4b. De tels éléments thermo électriques 3 fonctionnent, selon l'effet Seebeck, en permettant de créer un courant électrique dans une charge connectée entre lesdites faces 4a, 4b soumises au gradient de température. De façon connue de l'homme du métier, de tels éléments sont constitués, par exemple, de Bismuth et de Tellurium (Bi₂Te₃).

Les éléments thermo électriques 3 sont, pour une première partie, des éléments 3P d'un premier type, dit P, permettant d'établir une différence de potentiel électrique dans un sens, dit positif, lorsqu'ils sont soumis à un gradient de température donné, et, pour l'autre partie, des éléments 3N d'un second type, dit N, permettant la création d'une différence de potentiel électrique dans un sens opposé, dit négatif, lorsqu'ils sont soumis au même gradient de température. Lesdits éléments thermo électriques 3 sont, par exemple, groupés par paire, chaque paire étant formée d'un dit élément thermo électrique de type P et d'un dit élément thermo électrique de type N.

Les éléments thermo électriques 3 sont ici de forme annulaire et sont notamment de section transversale aplatie. Les faces actives 4a, 4b sont donc situées sur la périphérie intérieure et extérieure de la forme annulaire de sorte que les éléments thermo électriques 3 présente une face active intérieure 4a et une face active extérieure 4b. Cela permet ainsi de disposer le premier circuit 2 au moins en partie à l'intérieur des éléments thermo électrique 3 au contact de la face active intérieure 4a.

Le module 1 comprend également au moins une bague interne 6 disposée entre le premier circuit 2 et les éléments thermo électriques 3, c'est-à-dire au contact de la face intérieure 4a des éléments thermo électrique 3. La bague interne 6 est conductrice électrique et thermique et relie entre eux deux éléments thermo électriques 3 d'une même paire.

Le module 1 comprend en outre au moins une bague externe 7 au contact avec la face active extérieure 4b des éléments thermo électriques 3. La bague externe 7 est conductrice électrique et thermique et relie entre eux deux éléments thermo électriques 3 de deux paires voisines.

Ledit module 1 est ainsi configuré pour permettre une circulation de courant entre les faces actives intérieures 4a des éléments thermo électriques 3 d'une même paire grâce aux bagues internes 6 et une circulation de courant entre les faces actives extérieures 4b de deux éléments thermo électriques 3 voisins appartenant à deux paires différentes grâce aux bagues externes 7. On établit de la sorte une circulation de courant en série d'un élément thermo électrique à l'autre, en faisant alterner les éléments thermo électrique de type P et de type N.

Le module 1 de l'invention comprend en outre une gaine 8 hermétique, entourant ici les éléments thermo électriques 3 et le premier circuit 2 de sorte qu'ils sont situés à l'intérieur de la gaine 8. La gaine 8 est ainsi disposée du coté de la face active extérieure 4b des éléments thermo électriques. Elle est ici au contact des bagues externes 7.

Cette gaine 8 sépare hermétiquement les éléments thermo électriques 3 et le premier circuit 2 de l'extérieur du module 1, c'est-à-dire qu'elle empêche tout contact d'un fluide extérieur au module 1 avec les éléments thermo électriques 3 et le premier circuit 2 situés à l'intérieur de la gaine ainsi que, ici, avec les bagues internes 6 et externes 7. Autrement dit, l'ensemble est encapsulé dans la gaine 8 qui vient l'envelopper.

La gaine 8 est également conductrice thermique. Elle peut ainsi être positionné au contact d'un liquide de refroidissement, dit liquide froid, afin de fournir aux éléments thermo électriques 3, notamment par l'intermédiaire des bagues externe 7, la source froide nécessaire pour fournir le gradient de température dont les éléments thermo électriques ont besoin pour générer de l'électricité sans que le liquide n'entre en contact avec les bagues intérieures 6, les bagues extérieures 7, les éléments thermo électrique 3 et le premier circuit 2.

La gaine 8 est en outre isolante électrique. Elle permet ainsi d'isoler électriquement la bague externe 7 et les éléments thermo électriques 3 de l'extérieur du module 1 et en particulier du liquide froid destiné à être en contact avec la gaine 8.

Le module 1 de l'invention pourra comprendre également des intercalaires 9 disposés entre les éléments thermo électriques 3 voisins de manière à les isoler électriquement les uns des autres au niveau d'une de leurs faces actives 4a, 4b. Ainsi, les intercalaires isolent électriquement les faces extérieures 4b des éléments thermo électriques 3 d'une même paire et les faces intérieures 4a des éléments thermo électriques 3 voisins de deux paires différentes. Les intercalaires 9 participent en outre à favoriser l'étanchéité du module procurée par la gaine 8 comme vu précédemment.

Dans un mode particulier de l'invention, et comme illustré sur les figures 1 et 2, c'est la gaine 8 qui comprend ces intercalaires 9 de sorte que la gaine 8 s'étend entre lesdits éléments thermo électrique. Ils sont par exemple issus de matière avec la gaine 8. Cela facilite notamment la fabrication et l'assemblage du module 1.

La gaine 8 est avantageusement thermo rétractable de sorte que le montage étanche de la gaine 8 sur le reste du module est facilité.

Comme expliqué précédemment, l'invention concerne aussi un dispositif thermo électrique 10 tel qu'illustré à la figure 3. Ce dispositif 10 comprend au moins un module 1 tel que décrit précédemment et en particulier une pluralité de modules 1. Le dispositif 10 comprend également un boitier 11 définissant un volume et à l'intérieur duquel sont insérés les modules 1. Les modules 1 sont ici empilés les uns au dessus des autres et disposés selon deux rangées cote à cote.

Le dispositif 10 est configuré pour faire circuler le liquide froid au contact desdits modules thermo électriques 1. C'est ici le boitier 11 qui définit un deuxième circuit à l'intérieur duquel circule le liquide froid en passant entre lesdits modules 1.

Le dispositif 10 comprend une première zone dans laquelle le liquide froid est destiné à être en contact avec la gaine des modules 1.

Le dispositif 10 comprend également une boite collectrice 15 située au niveau d'une deuxième extrémité longitudinale 16 des modules 1. Ainsi, le fluide chaud peut circuler depuis une première extrémité longitudinale 17 d'un premier groupe de modules 1 jusqu'à la boite collectrice 15, qui le dirige alors vers un deuxième groupe de modules 1 dans lequel il entre par la deuxième extrémité longitudinale 16. Le fluide chaud circule alors dans le sens contraire jusqu'à sortir du deuxième groupe de modules 1 puis du dispositif 10 au niveau de la même première extrémité longitudinale 17 des modules 1 par laquelle il est rentré.

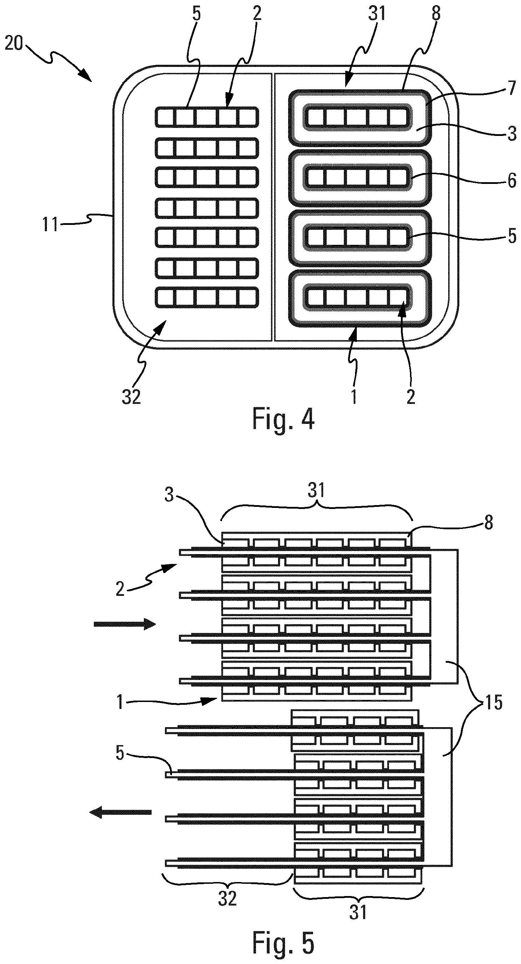

L'invention concerne aussi un échangeur de chaleur 20, comprenant un tel dispositif 10. L'échangeur comprend alors, comme illustré sur les figures 4 et 5, une deuxième zone 32, située à l'intérieur dudit boitier 11 et dans laquelle le premier circuit 2 et le liquide froid sont directement en contact.

Sur ces exemples de réalisation, la première zone 31 et la deuxième zone 32 sont positionnées en séries selon le premier circuit 2, c'est-à-dire dans le sens de circulation du fluide chaud. Ainsi, le fluide chaud entre dans l'échangeur 20 au niveau de la première zone 31, parcourt le premier circuit 2 dans modules 1 et continue son parcours dans le premier circuit 2 en sortant des modules 2 et donc en entrant dans la deuxième zone 32 avant de sortir de l'échangeur 20.

On peut remarquer que le premier circuit 2 est ici continue sur tout le trajet du fluide chaud et notamment entre la première et la deuxième zone 31, 32, c'est-à-dire que les tubes 5 sont continues. Ainsi, la première zone 31 permet aux modules 1 de générer de l'électricité grâce au gradient de température créé par le fluide chaud et le liquide froid. Le fluide chaud est alors isolé du liquide froid par la bague interne, les éléments thermo électriques 3, la bague externe et la gaine 8. Il ne change donc que peu de température lorsqu'il parcourt les modules 1 ce qui garanti l'efficacité de générateur électrique des modules 1.

En revanche, lorsque le fluide chaud est dans la deuxième zone 32, le deuxième circuit est directement en contact avec le liquide froid. L'échange de chaleur entre les deux fluides est donc beaucoup plus important et le refroidissement de fluide chaud pourra alors s'effectuer.

On peut noter que l'invention permet de répartir les zones 31, 32, dans l'échangeur 20 en fonction de l'efficacité électrique et thermique que l'on souhaite obtenir. Ainsi, pour augmenter la production d'électricité, on augmente la dimension de la première zone 31 alors que pour augmenter le refroidissement du fluide chaud, on augmente les dimensions de la deuxième zone 32. La figure 4 illustre un exemple dans lequel 50% du volume interne défini par le boitier 11 est occupé par la première zone 31 et 50 % par la deuxième zone 32. Dans l'exemple de réalisation de la figure 5, 80% du volume interne est occupé par la première zone 31 et 20 % par la deuxième zone 32.

Le liquide peut parcourir, par exemple, parallèlement la première et la deuxième zone 31, 32 comme illustré sur la figure 4. L'échangeur comprend ici une cloison 21 séparant le liquide froid au contact du premier circuit 2 dans la deuxième zone 32 du liquide froid au contact des modules 1 dans la première zone 31. Le liquide froid au contact des modules 1 n'échange que peu de chaleur avec le premier circuit 2 ce qui garanti l'efficacité des éléments thermo générateurs.

Selon une alternative, la première zone et la deuxième zone sont situées en séries dans le sens de circulation du liquide. Le liquide froid apporte d'abord la source froide aux modules 1 sans échanger beaucoup de chaleur avec le premier circuit 2 puis échange directement de la chaleur avec le premier circuit 2 afin de refroidir le fluide chaud, ou inversement pour favoriser l'échange thermique, le gradient de température pour la fonction thermo électrique restant alors suffisant compte-tenu de la capacité calorifique élevée du fluide froid, celui-ci étant liquide.

## Revendications

1. Module thermo électrique (1), comprenant au moins un élément thermo électrique (3) permettant la génération d'un courant électrique à partir d'un gradient de température appliqué entre deux de ses faces actives (4a, 4p), un premier circuit (2), dit chaud, apte à permettre la circulation d'un premier fluide en relation d'échange thermique avec l'une desdites faces actives et une gaine (8) entourant le ou lesdits éléments thermo électriques (3) et ledit circuit chaud (2) de sorte que la gaine (8) est agencée pour établir un contact thermique entre un liquide, dit froid, de température inférieure à celle du premier fluide, et l'autre desdites faces actives et séparer hermétiquement d'une part ledit liquide froid et d'autre part le ou lesdits éléments thermo électriques (3) et ledit circuit chaud (2).

2. Module thermo électrique (1) selon la revendication 1, dans lequel l'élément thermo électrique (3) est de forme annulaire de sorte qu'il comprend une face intérieure, correspondant à la face active (4a) en relation d'échange thermique avec le circuit chaud (2), et une face extérieure, correspondant à l'autre desdites faces actives (4b).

3. Module thermo électrique (1) selon la revendication 2, dans lequel l'élément thermo électrique (3) est de section transversale aplatie.

4. Module thermo électrique (1) selon l'une quelconque des revendications précédentes, dans lequel la gaine (8) est isolante électrique.

5. Module thermo électrique (1) selon l'une quelconque des revendications précédentes, dans lequel le module thermo électrique comprend des intercalaires (9) isolant électriquement deux éléments thermo électriques (3) voisins au niveau d'une de leurs faces actives (4a, 4b).

6. Module thermo électrique (1) selon la revendication 5, dans lequel la gaine (8) comprend lesdits intercalaires (9).

7. Module thermo électrique (1) selon l'une quelconque des revendications précédentes, dans lequel la gaine (8) est thermo rétractable.

8. Dispositif thermo électrique (10) comprenant un boitier (11) et au moins un module thermo électrique (1) selon l'une quelconque des revendications précédentes, ledit module (1) étant inséré dans le boitier (11) et ledit boitier (11) comprenant une première zone (31) dans laquelle ledit liquide froid est destiné à être en contact avec ladite gaine (8).

9. Dispositif thermo électrique (10) selon la revendication 8, dans lequel ledit boitier (11) définit, au moins en partie, un deuxième circuit dans lequel ledit liquide froid est destiné à circuler.

10. Echangeur de chaleur (20), comprenant un dispositif thermo électrique (10) selon la revendication 8 ou 9, ledit boitier comprenant une deuxième zone (32) dans laquelle le circuit chaud (2) est configuré pour être directement en contact avec le liquide froid.

11. Echangeur de chaleur (20) selon la revendication 10, dans lequel la première zone (31) et la deuxième zone (32) sont positionnées en séries dans le sens de circulation du fluide chaud.

12. Echangeur de chaleur (20) selon la revendication 11, dans lequel le premier circuit est configuré de sorte que la première zone (31) est située en amont de la deuxième zone (32) dans le sens de circulation du fluide chaud.

13. Echangeur de chaleur (20) selon l'une quelconque des revendications 10 à 12, dans lequel l'échangeur (20) est configuré de sorte que le liquide froid est destiné à parcourir parallèlement la première zone (31) et la deuxième zone (32).

14. Echangeur de chaleur (20) selon la revendication 13, dans lequel l'échangeur (20) comprend une cloison (21) séparant la première zone (31) de la deuxième zone (32) de sorte que le liquide froid circulant dans la première zone (31) et le liquide froid circulant dans la deuxième zone (32) sont séparés.

15. Echangeur de chaleur (20) selon l'une quelconque des revendications 10 à 12, dans lequel la première zone (31) et la deuxième zone (32) sont situées en séries dans le sens de circulation du liquide froid.

16. Echangeur de chaleur (20) selon l'une quelconque des revendications 10 à 15, dans lequel la première zone (31) représente 40% à 90% d'un volume défini par l'intérieur du boitier (11), la deuxième zone représentant la portion restante dudit volume.

17. Echangeur de chaleur (20) selon l'une quelconque des revendications 10 à 16, dans lequel le fluide chaud comprend des gaz EGR.

18. Circuit de recirculation des gaz EGR d'un véhicule automobile comprenant un dispositif thermo électrique selon l'une quelconque des revendications 8 ou 9 ou un échangeur de chaleur (20) selon l'une quelconque des revendications 10 à 17.

## Patentansprüche

1. Thermoelektrisches Modul (1), umfassend mindestens ein thermoelektrisches Element (3), das die Erzeugung eines elektrischen Stroms aus einem Temperaturgradienten ermöglicht, der zwischen zwei seiner aktiven Flächen (4a, 4p) angelegt wird, einen ersten Kreislauf (2), als heiß bezeichnet, der geeignet ist, die Zirkulation eines ersten Fluids in Wärmeaustauschbeziehung mit einer der aktiven Flächen zu ermöglichen, und eine Hülle (8), die das/die thermoelektrische(n) Element(e) (3) und den heißen Kreislauf (2) umgibt, derart, dass die Hülle (8) dazu ausgelegt ist, einen thermischen Kontakt zwischen einer Flüssigkeit, als kalt bezeichnet, mit einer niedrigeren Temperatur als die des ersten Fluids, und der anderen der aktiven Flächen herzustellen und die kalte Flüssigkeit auf der einen Seite und das/die thermoelektrische(n) Element(e) (3) und den heißen Kreislauf (2) auf der anderen Seite hermetisch zu trennen.

2. Thermoelektrisches Modul (1) gemäß Anspruch 1, wobei das thermoelektrische Element (3) ringförmig ausgebildet ist, sodass es eine Innenfläche, die der aktiven Fläche (4a) in Wärmeaustauschbeziehung mit dem heißen Kreislauf (2) entspricht, und eine Außenfläche, die der anderen der aktiven Flächen (4b) entspricht, umfasst.

3. Thermoelektrisches Modul (1) gemäß Anspruch 2, wobei das thermoelektrische Element (3) einen abgeflachten Querschnitt aufweist.

4. Thermoelektrisches Modul (1) gemäß einem der vorstehenden Ansprüche, wobei die Hülle (8) elektrisch isoliert ist.

5. Thermoelektrisches Modul (1) gemäß einem der vorstehenden Ansprüche, wobei das thermoelektrische Modul Abstandshalter (9) umfasst, die zwei benachbarte thermoelektrische Elemente (3) an einer ihrer aktiven Flächen (4a, 4b) elektrisch isolieren.

6. Thermoelektrisches Modul (1) gemäß Anspruch 5, wobei die Hülle (8) die Abstandshalter (9) umfasst.

7. Thermoelektrisches Modul (1) gemäß einem der vorstehenden Ansprüche, wobei die Hülle (8) wärmeschrumpfbar ist.

8. Thermoelektrische Vorrichtung (10), umfassend ein Gehäuse (11) und mindestens ein thermoelektrisches Modul (1) gemäß einem der vorstehenden Ansprüche, wobei das Modul (1) in das Gehäuse (11) eingesetzt ist und das Gehäuse (11) eine erste Zone (31) umfasst, in der die kalte Flüssigkeit dafür vorgesehen ist, in Kontakt mit der Hülle (8) zu sein.

9. Thermoelektrische Vorrichtung (10) gemäß Anspruch 8, wobei das Gehäuse (11) zumindest teilweise einen zweiten Kreislauf definiert, in dem die kalte Flüssigkeit zirkulieren soll.

10. Wärmetauscher (20), umfassend eine thermoelektrische Vorrichtung (10) gemäß Anspruch 8 oder 9, wobei das Gehäuse eine zweite Zone (32) umfasst, in der der heiße Kreislauf (2) dazu ausgelegt ist, in direktem Kontakt mit der kalten Flüssigkeit zu stehen.

11. Wärmetauscher (20) gemäß Anspruch 10, wobei die erste Zone (31) und die zweite Zone (32) in Zirkulationsrichtung des heißen Fluids hintereinander angeordnet sind.

12. Wärmetauscher (20) gemäß Anspruch 11, wobei der erste Kreislauf so ausgelegt ist, dass die erste Zone (31) stromaufwärts der zweiten Zone (32) in Zirkulationsrichtung des heißen Fluids angeordnet ist.

13. Wärmetauscher (20) gemäß einem der Ansprüche 10 bis 12, wobei der Wärmetauscher (20) so ausgelegt ist, dass die kalte Flüssigkeit dazu bestimmt ist, parallel zu der ersten Zone (31) und der zweiten Zone (32) zu fließen.

14. Wärmetauscher (20) gemäß Anspruch 13, wobei der Wärmetauscher (20) eine Trennwand (21) umfasst, die die erste Zone (31) von der zweiten Zone (32) trennt, sodass die in der ersten Zone (31) zirkulierende kalte Flüssigkeit und die in der zweiten Zone (32) zirkulierende kalte Flüssigkeit getrennt sind.

15. Wärmetauscher (20) gemäß einem der Ansprüche 10 bis 12, wobei die erste Zone (31) und die zweite Zone (32) in Zirkulationsrichtung der kalten Flüssigkeit hintereinander angeordnet sind.

16. Wärmetauscher (20) gemäß einem der Ansprüche 10 bis 15, wobei die erste Zone (31) 40% bis 90% eines Volumens darstellt, das durch das Innere des Gehäuses (11) definiert ist, und die zweite Zone den verbleibenden Teil des Volumens darstellt.

17. Wärmetauscher (20) gemäß einem der Ansprüche 10 bis 16, wobei das heiße Fluid AGR-Gase umfasst.

18. Kreislauf zum Umwälzen der AGR-Gase eines Kraftfahrzeugs, umfassend eine thermoelektrische Vorrichtung gemäß einem der Ansprüche 8 oder 9 oder einen Wärmetauscher (20) gemäß einem der Ansprüche 10 bis 17.

## Claims

1. Thermoelectric module (1), comprising at least one thermoelectric element (3) making it possible to generate an electric current from a temperature gradient applied between two of its active faces (4a, 4p), a first so-called hot circuit (2), suitable for allowing the circulation of a first fluid in heat exchange relation with one of said active faces and a cladding (8) surrounding said thermoelectric element or elements (3) and said hot circuit (2) such that the cladding (8) is arranged to establish a thermal contact between a so-called cold liquid, of a temperature lower than that of the first fluid, and the other of said active faces and hermetically separate, on the one hand, said cold liquid and, on the other hand, said thermoelectric element or elements (3) and said hot circuit (2).

2. Thermoelectric module (1) according to Claim 1, in which the thermoelectric element (3) is of annular form such that it comprises an inner face, corresponding to the active face (4a) in heat exchange relation with the hot circuit (2), and an outer face, corresponding to the other of said active faces (4b).

3. Thermoelectric module (1) according to Claim 2, in which the thermoelectric element (3) is of flattened cross section.

4. Thermoelectric module (1) according to any one of the preceding claims, in which the cladding (8) is electrically insulating.

5. Thermoelectric module (1) according to any one of the preceding claims, in which the thermoelectric module comprises separators (9) electrically insulating two neighboring thermoelectric elements (3) at one of their active faces (4a, 4b).

6. Thermoelectric module (1) according to Claim 5, in which the cladding (8) comprises said separators (9).

7. Thermoelectric module (1) according to any one of the preceding claims, in which the cladding (8) is heat-shrinkable.

8. Thermoelectric device (10) comprising a casing (11) and at least one thermoelectric module (1) according to any one of the preceding claims, said module (1) being inserted into the casing (11) and said casing (11) comprising a first zone (31) in which said cold liquid is intended to be in contact with said cladding (8).

9. Thermoelectric device (10) according to Claim 8, in which said casing (11) defines, at least partly, a second circuit in which said cold liquid is intended to circulate.

10. Heat exchanger (20), comprising a thermoelectric device (10) according to Claim 8 or 9, said casing comprising a second zone (32) in which the hot circuit (2) is configured to be directly in contact with the cold liquid.

11. Heat exchanger (20) according to Claim 10, in which the first zone (31) and the second zone (32) are positioned in series in the direction of circulation of the hot fluid.

12. Heat exchanger (20) according to Claim 11, in which the first circuit is configured such that the first zone (31) is situated upstream of the second zone (32) in the direction of circulation of the hot fluid.

13. Heat exchanger (20) according to any one of Claims 10 to 12, in which the exchanger (20) is configured such that the cold liquid is intended to run parallel through the first zone (31) and the second zone (32).

14. Heat exchanger (20) according to Claim 13, in which the exchanger (20) comprises a partition (21) separating the first zone (31) from the second zone (32) such that the cold liquid circulating in the first zone (31) and the cold liquid circulating in the second zone (32) are separated.

15. Heat exchanger (20) according to any one of Claims 10 to 12, in which the first zone (31) and the second zone (32) are situated in series in the direction of circulation of the cold liquid.

16. Heat exchanger (20) according to any one of Claims 10 to 15, in which the first zone (31) represents 40% to 90% of a volume defined by the interior of the casing (11), the second zone representing the remaining portion of said volume.

17. Heat exchanger (20) according to any one of Claims 10 to 16, in which the hot fluid comprises EGR gases.

18. EGR gas recirculation circuit of a motor vehicle comprising a thermoelectric device according to any one of Claims 8 or 9 or a heat exchanger (20) according to any one of Claims 10 to 17.
